# EUROPEAN PATENT SPECIFICATION

(11) **EP 1 282 523 B1**
(45) Date of publication and mention of the grant of the patent: **18.10.2006**
(21) Application number: 01932883.0
(22) Date of filing: 02.05.2001
(51) Int. Cl.: B41M 7/00, B41M 5/00

(54) **INK RECEPTOR SHEET AND ITS PROCESS OF USE**
TINTENEMPFANGSBLATT BZW. SEIN ANWENDUNGSVERFAHREN
FEUILLE RECEPTRICE D'ENCRE ET PROCEDE D'UTILISATION

(30) Priority: 17.05.2000 EP 00110550
(43) Date of publication of application: 12.02.2003
(73) Proprietor: E. I. du Pont de Nemours and Company, Wilmington, Delaware 19898 (US)
(72) Inventor: SONDERGELD, Manfred, 63165 Muehlheim (DE); STRUEWE, Volker, 63128 Dietzenbach (DE)
(74) Representative: Thomson, James B.
(86) International application number: PCT/US2001/014162
(87) International publication number: WO 2001/087636

(56) References cited:
- EP-A- 0 782 931
- WO-A-95/06564
- US-A- 5 766 398
- US-A- 5 795 425
- US-A- 5 984 467

## Description

The invention relates to an ink receptor sheet, a printing system comprising such an ink receptor sheet and a transfer element, a process for preparing an image on a permanent substrate by formation of an ink image, and an imaged article made by such a process.

### BACKGROUND OF INVENTION

Ink jet printing is a well known process in the art to make multicolor images. It is a non-impact method for recording information in response to an electronic signal, such as that generated by a computer. In this process, ink droplets are emitted from a nozzle and deposited on substrates, mainly paper or polymer films and sheets, to form an ink image. To achieve high quality images in ink jet printing, the substrate is usually coated with at least one layer that rapidly absorbs the ink. For the inks are mainly composed of water and a colorant, such coating formulations are hydrophilic and contain appropriate absorptive materials.

WO 95/06564 discloses an ink jet receptive element comprising a temporary carrier layer, a protective layer, and an ink receptive layer. An imaging process is disclosed which comprises depositing an ink image layer on the surface of an ink receptive element, so that the ink image layer is adhered to the surface of an ink receptive layer; pressure laminating and adhering a receptor substrate to the ink image layer to form a laminated element; and removing the temporary carrier layer from the protective layer of the laminated image element to form a protected imaged substrate.

It is also possible to transfer the ink image present on the ink receiving layer of an ink receiving sheet, comprising a temporary support and an ink receiving layer, to a permanent substrate. After peeling of the temporary support, the image is transferred to the permanent substrate.

Alternatively, the imaged ink receptor sheet may first be laminated to a transfer element. Then the temporary support of the ink receptor sheet is removed, the imaged ink receiving layer on the transfer element is then laminated to the desired permanent substrate, and finally the transfer element is removed.

Ink jet printing materials and transfer processes are known from US 5,023,129, US 5,141,797, and US 5,984,467. Ink receptor sheets which provide ink images with improved durability are known from US 5,429,860 and US 5,537,137. These materials contain special compounds in the ink receiving layer which compounds are crosslinked by heat, by actinic radiation, or by chemical treatment after ink jet printing. Another method to provide durable ink jet images is disclosed in US 5,766,398. This method provides images with a protective layer on the ink image by using an ink receptor sheet comprising a temporary support, a polymeric film, and an ink receiving layer. After applying an image by ink jet printing to the ink receiving layer, a substrate comprising an adhesive layer is laminated to the imaged ink receptor sheet, and the temporary support of the ink receptor sheet is removed, whereby the polymeric film is revealed as a protective layer of the ink image.

There are still problems with the ink jet materials and processes of the prior art, such as they often have narrow handling latitude during the required lamination and peeling steps. Either high lamination temperatures and slow lamination speeds are necessary or it is difficult to separate the right layers in the peeling steps to get the desired end result.

### SUMMARY OF INVENTION

Therefore, it was an objective of the present invention to enhance the handling latitude during the required lamination and peeling steps of ink jet printing processes and/or to provide durable and resistant images made by such ink jet printing processes.

In a first aspect, this objective is achieved by an ink receptor sheet according to claim 1.

In a second aspect, the invention is directed to an ink jet printing system comprising in combination an ink receptor sheet as previously described and a transfer element comprising a second temporary support and an adhesive layer.

In a third aspect, the invention is directed to a process for preparing an image on a permanent substrate comprising the steps of:
(a) imagewise applying at least one ink image on an ink receptor sheet as previously described, whereby the ink image is adjacent the ink receiving layer;
(b) contacting, typically laminating, the imaged ink receptor sheet to a transfer element as previously described, whereby the ink image is adjacent the adhesive layer;
(c) removing the second temporary support to reveal the adhesive layer on top of the imaged ink receptor sheet,
(d) contacting, typically laminating, the imaged ink receptor sheet with a permanent substrate, whereby the adhesive layer is adjacent the permanent substrate,
(e) overall exposing with actinic radiation the permanent substrate and imaged ink receptor sheet sandwich through the first temporary support, and
(f) removing the first temporary support to reveal the final image on the permanent substrate, wherein the image is encased between the ink receiving layer and the adhesive layer. Typically an ink jet printer is used for the imagewise application of the image.

A further process for preparing an image on a permanent substrate according to claim 21 is provided.

In a fourth aspect, the invention is directed to an imaged article according to claim 24. Typically the image is an ink jet image.

### DETAILED DESCRIPTION OF INVENTION

The present invention provides an ink receptor sheet which enhances the handling latitude during the required contacting, typically lamination, and peeling steps of ink jet printing transfer processes. It is not necessary to use special coated or treated synthetic resin films as temporary supports for the ink receptor sheet. No adhesion failure occurs during the peeling processes of temporary supports, even with non-pretreated temporary supports. Therefore, no edge lifting of layers or partial peel off of layer surfaces damaging the final images results. Furthermore, the present invention provides durable and resistant images made by such ink jet printing processes, and simultaneously provides a protective layer for the final images.

### Ink receptor sheet

The ink receptor sheet comprises a temporary support, a photopolymerizable layer, and an ink receiving layer.

### Temporary support:

Suitable supports are, for example, synthetic resin films of polyethylene, polypropylene, polyamides, or polyesters. Polyethylene terephthalate films are particularly preferred. Supports having smooth or rough surfaces can be used. Support films having release layers or surfaces treated by electrical discharge are also suitable. The thickness of the support is usually at least about 12 µm, typically about 20-200 µm, more typically about 75-150 µm.

### Photopolymerizable layer:

Preferably, the photopolymerizable layer in its non-photopolymerized state shows high adhesion to the ink receiving layer and the first temporary support, whereas the photopolymerizable layer in its photopolymerized state shows high adhesion to the ink receiving layer and low adhesion to the first temporary support.

The photopolymerizable layer comprises at least one polymeric binder, at least one photopolymerizable, ethylenically unsaturated monomer, and at least one photoinitiator or photoinitiator system.

Especially, the photopolymerizable layer comprises at least one polymer selected from the group consisting of polyvinylformal, polyvinyl butyral, polyvinyl alcohol, polyvinyl acetate, polyurethane esters, polyacrylates containing carboxylic groups, polymethacrylates, and copolymers of (meth)acrylic acid with (meth)acrylic esters, (meth)acrylic amides, vinyl compounds, styrene, and butadiene. Preferred are polyvinyl alcohols and copolymers of alkyl methacrylates, e.i. methyl methacrylate, ethyl methacrylate, butyl methacrylate, and alkyl acrylates, e.i. methyl acrylate, ethyl acrylate, butyl acrylate. Especially mixtures of such polymers are suitable. For aqueous coating solutions polymer latices are used. Also suitable are the crosslinked polymers disclosed in US 4,892,802.

Conventional photopolymerizable, ethylenically unsaturated monomers may be used in the ink receptor sheets of this invention. Especially those disclosed in US 4,892,802 are typical. Typically used are acrylic and methacrylic acid esters of polyols, such as, diethylene glycol diacrylate, 1,3-propanediol dimethacrylate, 1,5-pentanediol dimethacrylate, trimethylol propane trimethacrylate, bisacrylates or methacrylates of bisphenol A or its alkoxylated derivatives, and pentaerythritol tetraacrylate or methacrylates. More typically, the photopolymerizable layer comprises at least one monomer selected from the group consisting of trimethylol propane trimethacrylate, bisacrylates or methacrylates of bisphenol A, and pentaerythritol tetraacrylate or methacrylates.

As a photoinitiator or photoinitiator system, practically all compounds known for this purpose can be used. Typically compounds and systems are disclosed in US 4,892,802. Epecially preferred are diacetyl, benzil, benzil dimethyl ketal, benzoin, benzoin methyl or ethyl ether, a combination of Michler's ketone and benzophenone, and systems of substituted thioxanthones and tertiary amines.

In addition to the main components described in the foregoing, the photopolymerizable layer of the present invention may comprise conventional additives like, for example, UV absorbers, thermal stabilizers, plasticizers" and fillers. In particular, the addition of fillers, such as, for example, silicates, aluminium oxides, and silicon dioxides are advantageous. Pyrogenic and precipitated silicic acids are preferred. Fillers are present in an amount of from about 0 to about 15 % by weight, typically 0 to 10 % by weight, based on the total weight of the layer.

The photopolymerizable layer of the invention generally comprises about 25 to about 75 % by weight, typically about 35 to about 50 % by weight of the polymeric binder; about 10 to about 60 % by weight, typically about 15 to about 50 % by weight of the photopolymerizable, ethylenically unsaturated monomer; about 0.1 to 10 % by weight, typically about 1 to about 5 % by weight of the photoinitiator or photoinitiator system; and about 0 to about 10 % by weight, typically about 1 to about 10 % by weight of additives; based on the total weight of the photopolymerizable layer.

The photopolymerizable layer of this invention can be prepared by generally known coating methods. For this purpose, aqueous as well as organic coating solutions can be used, as, for example, methylene chloride, toluene/methanol mixtures, or other mixtures of aromatic solvents and alcohols, esters, or ketones. Preferably, the photopolymerizable layer is made by emulsion coating. Subsequently, the coated layer is dried. The coating weight of the photopolymerizable layer is about 25 to about 80 mg/dm², typically about 40 to about 60 mg/dm².

### Ink receiving layer

In general, all ink receiving materials of the state of the art, including those which are composed of at least two layers, can be used for preparing the ink receiving layer of this invention. Suitable ink receiving materials are described in US 5,023,129, US 5,141,797, US 5,984,467, US 5,429,860 and US 5,537,137. Preferably, the ink receiving layers of the present invention are non-tacky. The ink receiving layer of the present invention typically comprises at least one hydrophilic polymer. More typically, the ink receiving layer comprises at least one polymer selected from the group consisting of homo- and copolymers of vinyl alcohol and/or pyrrolidone; homo- and copolymers of acrylic acid, methacrylic acid, and/or maleic acid and /or maleic acid anhydride, and/or their metal salts and/or their amine salts; gelatine, and starch. Especially mixtures of polyvinyl alcohols and/or copolymers of maleic acid or maleic acid anhydride with comonomers like methyl vinyl ether, are used. The hydrophilic polymer generally will be water-soluble in order that it may be applied using conventional aqueous coating techniques.

Additional compounds of the ink receiving layer may be, for example, UV absorbers, coating additives, plasticizers, and fillers. When polymers comprising acid groups are used, preferably compounds which neutralize these acid groups are added to adjust the pH value. Typically, amines are used; especially tertiary amines like triethanol amine, are used. In particular, the addition of fillers, such as, for example, silicates, aluminium oxides, and silicon dioxides is advantageous. Pyrogenic and precipitated silicic acids are preferred. Fillers are present in an amount of from about 0 to about 15 % by weight, typically about 0 to about 10 % by weight, based on the total weight of the layer.

The ink receiving layer of this invention can be prepared by generally known coating methods. Subsequently, the coated layer is dried. The coating weight of the ink receiving layer is about 50 to about 150, typically about 60 to about 100 mg/dm².

### Transfer element

The transfer element of the present invention comprises a temporary support and an adhesive layer. Suitable supports are, for example, synthetic resin films of polyethylene, polypropylene, polyamides, or polyesters. Polyethylene terephthalate films particularly preferred. Supports having smooth or rough surfaces can be used. Support films having release layers or surfaces treated by electrical discharge are also suitable. The thickness of the support is usually at least about 12 µm, typically about 20-about 130 µm, more typically at about 50 to about 100 µm.

The adhesive layer may comprise at least one thermoplastic polymer, for example at least one polymer selected from the group consisting of acrylate and methacrylate copolymers, vinyl acetate copolymers, and polyamides. Preferably the adhesive layer of the transfer element comprises at least one crystalline polymer. Especially preferred are polycaprolactones. The adhesive layer can also contain additives, such as, for example, surfactants and fillers. In particular, addition of fillers, such as, for example, silicates, aluminium oxides, and silicon dioxides are advantageous. Pyrogenic and precipitated silicic acids are preferred. Fillers are present in an amount of from about 0 to about 15 % by weight, typically about 0 to about10 % by weight, based on the total weight of the layer.

The transfer element of this invention can be prepared by known methods. For this purpose, coating solutions for forming the adhesive layer can be coated on the supports from currently available solvents, preferably organic solvents, such as, for example, methylene chloride, toluene/methanol mixtures, or other mixtures of aromatic solvents and alcohols, esters, or ketones and subsequently dried. The coating weight of the adhesive layer is about 30 to about 100 mg/dm², typically about 40 to about 80 mg/dm².

### Inks

The inks used in the ink jet printing process of the present invention are well known in the art. The ink compositions usually comprise a carrier medium, normally water, and a colorant, which may be a dye or a pigment dispersion. Furthermore, additives like detergents, thickeners, organic solvents, etc. may be present. Suitable ink compositions are described in US 5,984,467 and US 5,537;137.

### Permanent substrate

The imaged ink receptor sheet of the present invention may be applied to many types of permanent substrates by use of the adhesive layer of the transfer element. Some permanent substrates include paper, polymer foils, metal, or card board.

### Applications

The ink receptor sheet provided by the present invention may receive ink printed by conventional ink jet printers, such as thermal or bubble jet printers, piezoelectric printers, continuous flow printers, or valve jet printers. After the ink is printed on the ink receiving layer of the ink receptor sheet, the printed sheet is air dried.

Then a transfer element is contacted to the imaged ink receptor sheet. Typically, it is laminated with a conventional laminator, e.g. an EasySprint® Desktop laminator (E.I du Pont de Nemours& Company, Wilmington, DE). The temperature of the laminator rollers is usually at least about 80 °C, typically about 90 to about 130°C.

The temporary support of the transfer element is peeled off manually or automatically, whereby the adhesive layer of the transfer element is transferred to the imaged ink receptor sheet. The temporary support is peeled off preferably after cooling to room temperature. More typical is an additional hold time of 1-5 min.

The imaged ink receptor plus the adhesive layer from the transfer element are then contacted, typically laminated, like in the previous contact/lamination step to a permanent substrate. After this contact, typically lamination, the photopolymerizable layer of the ink receptor sheet and permanent substrate sandwich is overall exposed with actinic radiation through the temporary support of the ink receptor sheet for about 10 to about 30 sec. Some examples of suitable radiation sources are xenon lamps, mercury vapor lamps and carbon-arcs, laser fluorescent lamps with fluorescent materials emitting UV radiation and electronic flash devices.

Afterwards, the temporary support of the ink receptor sheet is easily peeled off to reveal the final ink jet image, encased between the adhesive and the ink receiving layers, and protected by the photopolymerized layer, on the permanent substrate. The temporary support of the ink receptor sheet is peeled off manually or automatically, typically after cooling to room temperature. More typical is an additional hold time of about 1 to about 5 min.

The overall exposure of the photopolymerizable layer of the ink receptor sheet can also be carried out before instead of after contacting, typically laminating, the imaged ink receptor sheet plus the adhesive layer from the transfer element to the permanent substrate.

Furthermore, it is possible to contact, typically laminate, a photosensitive layer to the imaged ink receiving layer of the ink receptor sheet under the same process conditions as described above before a transfer element is applied. Suitable photosensitive materials are positive- and negative-working materials as those disclosed in US 3,649,268, US 4,174,216, US 4,892,802, and US 4,053,313. Typically, photosensitive materials are those of US 4,892,802.

This photosensitive layer is imagewise exposed with actinic radiation by using radiation sources like those previously described to produce tacky and non-tacky areas. The photosensitive layer may comprise a strippable base on its top which may be stripped before or after imagewise exposure. Suitable materials for such bases are synthetic resin films of polyethylene, polypropylene, polyamides, or polyesters. Then a toner is applied to the tacky areas of the imagewise exposed photosensitive layer. Powder toners as well as pigmented foils may be used. Such toner materials are disclosed in US 3,649,268; US 3,620,726; 3,909,282; and US 5,372,910 and US 5,427,894. These additional steps of applying a photosensitive layer, imagewise exposing it, and adding a toner may be repeated at least twice. Then the further steps of the transfer process according to the present invention are conducted as described above.

It is also possible to laminate an imaged ink receptor sheet of the present invention to an adhesive coated permanent substrate without transferring the imaged ink receptor sheet to a transfer element. All further process steps are conducted as described previously. The adhesive coated permanent substrate preferably comprises an adhesive layer like that of the transfer element. A transfer element of this invention may be laminated to any substrate to form this adhesive layer.

### Industrial Utility

The ink receptor sheet, the ink jet printing system comprising the ink receptor sheet and a transfer element as well as the processes of the present invention have commercial utility for ink jet printing technologies, especially with aqueous ink dispersions. Pictorial as well as textured information may be printed. For multicolored images, yellow, cyan, magenta, and black inks may be used to advantage. Applications include desktop publishing, as well as wide format applications such as the printing of signs, banners, and the like. High quality images may be printed on a broad variety of substrates.

### EXAMPLES

The following examples illustrate the invention, but do not limit it. Parts and percentages are by weight, unless otherwise stated. The average molecular weights of the polymers are given as weight average (Mw). Percent hydrolysis is given as mole percent hydrolysis of acetate groups on dry basis.

### Example 1:

### (I) Ink receptor sheet

### Photopolymerizable layer

7 g of Elvanol® 52-22 (E.I du Pont de Nemours& Company, Wilmington, DE; polyvinyl alcohol, 87 - 89 % hydrolysis, viscosity of aqueous solution (4 % solids) at 20 °C by Hoeppler falling ball method: 21-26 mPa s) were dissolved in 96.4 g water. 3.5 g Irgacure® 651 (benzil dimethyl ketal) were dissolved in 25.9 g TMPTMA (trimethylol propane trimethacrylate). This monomer/initiator solution was added to the Elvanol® solution and emulsified with a high speed mixer for 5 min. The emulsion was diluted with 150 g water and 67.2 g Plextol® D540 (Polymer Latex, Marl, Germany; aqueous dispersion of acrylic polymer based on methyl methacrylate and n-butyl acrylate, Brookfield viscosity 3-10 Pa s, 50 % of solids) were added and mixed under moderate stirring. The emulsion/dispersion was coated with a doctor knife onto a 125 µm thick untreated polyester base which formed the temporary support of the ink receptor sheet and dried at room temperature. The resulting coating weight was 60 mg/dm².

### Ink receiving layer

3.6g Gantrez® S97 (ISPEurope, Guildford, GB; free acid of methyl vinyl ether/maleic anhydride copolymer, about Mw 2,200,000) were dissolved in 182.5 g water. 2.13 g Ludox® LS (E.I du Pont de Nemours& Company, Wilmington, DE; colloidal silica in water, 30 % of solids) were added and mixed. 2.8 g triethanolamine were added and mixed. 8.96 g Elvanol® 52-22 were added and stirred until dissolved. The final solution had a pH of 5.3 and a viscosity of 660 cP. The solution was coated with a Meyer bar onto the above mentioned photopolymerizable layer and dried at room temperature. The coating weight of the ink receiving layer was 80 mg/dm².

### Transfer element

10.56 g Capa® 650 (Solvay Interox, Warrington, GB; polycaprolactone Mw 50,000, melting range Tm 58-60 °C, glass transition temperature range Tg -60 to -70 °C) were dissolved in 80.1 g toluene and 8.9 g methanol. 0.44g Acematt® OK607 (Degussa Hüls; Germany; precipitated silica, 2 µm particle size) were added and dispersed under vigorous stirring. The solution was coated with a doctor knife onto a 50 µm thick release treated polyester base which formed the temporary support of the transfer element and dried at room temperature to form an adhesive layer. The coating weight was 60 mg/dm².

### Process of use

A wrong reading 4 - color image was printed onto the ink receptor sheet with an AX-4 Digital Cromalin® ink jet printer (E.I du Pont de Nemours & Company, Wilmington, DE). A very uniform print with complete ink acceptance and no image disturbances or "beading" was achieved. Only slight surface tackiness was observed directly after printing in areas where all 4 colors had been printed 100 % on top of each other. After 10 min. drying at room temperature the entire surface was found to be non-tacky.

The transfer element was laminated to the imaged ink receptor sheet with an EasySpzint® Desktop laminator (E.I du Pont de Nemours & Company, Wilmington, DE) at 115 °C roller temperature wherein the adhesive layer of the transfer element adhered to the imaged ink receiving layer. After cooling to room temperature and a 1 min. hold time the temporary support of the transfer element was peeled off without any residues. The adhesive layer of the transfer element was completely transferred to the printed ink receptor sheet without any adhesion failure or edge lifting at the photopolymerizable layer/temporary support interface of the ink receptor sheet.

The ink receptor sheet plus the adhesive layer of the transfer element were laminated to a 120 g/m² Ikonorex® paper (Ikono Zanders, Germany) with an EasySprint® Desktop laminator at 115 °C roller temperature. After the lamination the photopolymerizable layer was overall exposed through the temporary support of the ink receptor sheet for 15 sec in a commercial 1000 W UV exposure frame to render the photopolymerizable layer non-tacky. After the exposure the temporary support of the ink receptor sheet was easily peeled off without any damage of the surface or any adhesion failure between the layers or to the paper substrate.

### Example 2

### Ink receptor sheet

### Photopolymerizable layer

3.5 g Elvanol® 52-22 were dissolved in 46.8 g water. 1.75 g Irgacure® 651 were dissolved in 12.95 g TMPTMA. The monomer/initiator solution was emulsified in the Elvanol® solution as described in Example 1. The emulsion was diluted with 40 g water and 35 g Primal® CS-4000 (Röhm & Haas, Germany; aqueous dispersion of acrylic polymer, 48% of solids) was stirred in. The emulsion/dispersion was coated with a doctor knife onto a 125 µm thick untreated polyester base which formed the temporary support of the ink receptor sheet and dried at room temperature. The coating weight was 60 mg/dm².

### Ink receiving layer

3.19 g Gantrez® AN119 (ISPEurope, Guildford, GB; methyl vinyl ether/maleic anhydride copolymer, Mw about 2,160,000) were dissolved in 133.5g water at 80 °C. 9.9g Elvanol® 52-22 were added and dissolved at 80 °C. After cooling to room temperature 3.05 g triethanolamine were added and mixed. The final solution had a pH of 5.8 and a viscosity of 380 cP. The solution was coated onto the photopolymerizable layer and dried as described in example 1. The coating weight was 60 mg/dm².

### Process of use as described in Example 1

After printing onto the ink receptor sheet, the surface was only slightly tacky over areas where all 4 colors had been printed 100% on top of each other. After laminating the transfer element to the imaged ink receptor sheet and peeling the temporary support of the transfer element, the photopolymerizable layer was overall exposed. The imaged and exposed ink receptor sheet with the adhesive layer on top was then laminated to a 100 µm thick corona treated polyethylene foil. The temporary support of the ink receptor sheet was peeled off easily without any damage of the surface or any adhesion failure between the layers or to the polyethylene foil.

### Example 3

### Ink receptor sheet

### Photopolymerizable layer

12 g Elvacite® 2044 (E.I du Pont de Nemours & Company, Wilmington, DE; butyl methacrylate copolymer), 7 g TMPTA and1 g Irgacure® 651 were dissolved in 80 g toluene. The solution was coated with a doctor knife onto a 125 µm thick untreated polyester base which formed the temporary support of the ink receptor sheet and dried at room temperature. The coating weight was 40 mg/dm².

### Ink receiving layer

3.19 g Gantrez ®AN119 were dissolved in 133.5 g water at 80 °C.9.9 g Moviol® 4-88 (Clariant GmbH, Germany; polyvinyl alcohol, 88 % hydrolysis, viscosity 4 mPa s) were added and dissolved at 80 °C. After cooling to room temperature 3.05 g triethanolamine were added and mixed. The final solution had a pH of 5.4 and a viscosity of 140 cP. The solution was coated onto the photopolymerizable layer and dried as described in example 1. The coating weight was 80 mg/dm².

### Process of use as described in Example 1

After printing onto the ink receptor sheet, the surface was only slightly tacky over areas where all 4 colors had been printed 100 % on top of each other. After laminating the transfer element to the printed ink receptor sheet and peeling the temporary support of the transfer element, the imaged ink receptor sheet with the adhesive layer on top was laminated to a 200 µ thick aluminum foil. After the overall exposure of the photopolymerizable layer the temporary support of the ink receptor sheet was easily peeled off without any damage of the surface or any adhesion failure between the layers or to the aluminum foil.

### Example 4

A wrong reading 4 - color image was printed as described in Example 1 onto an ink receptor sheet according to Example 1. Then a positive Cromalin® sheet (E.I du Pont de Nemours & Company, Wilmington, DE), after removal of its cover sheet, was laminated on top of the imaged ink receiving layer with an EasySprint® Desktop laminator (E.I du Pont de Nemours & Company, Wilmington, DE) at 115°C roller temperature. This layer was imagewise exposed through its base to provide tacky and non-tacky areas. The base was peeled off, and a white powder toner was applied to the tacky areas to provide a background image for the ink jet image. The transfer element was then laminated to the imaged ink receptor sheet as described in Example 1 and the temporary support of the transfer element was peeled off without any residues. The adhesive layer of the transfer element was completely transferred to the printed ink receptor sheet without any adhesion failure or edge lifting at the photopolymerizable layer/temporary support interface of the ink receptor sheet.

The imaged ink receptor sheet plus the toned Cromalin® layer plus the adhesive layer of the transfer element were laminated to a clear polyester base with an EasySprint® Desktop laminator at 115°C roller temperature. After the lamination the photopolymerizable layer was overall exposed through the temporary support of the ink receptor sheet for 15 sec in a commercial 1000 W UV exposure frame to render the photopolymerizable layer non-tacky. After the exposure the temporary support of the ink receptor sheet was easily peeled off without any damage of the surface or any adhesion failure between the layers or to the paper receptor.

### Comparative Example 1

The solution for the ink receiving layer of Example 1 was directly coated onto a 125 µm thick untreated polyester base which formed the temporary support of the ink receptor sheet as described in Example 1. The coating weight was 80 mg/dm².

A wrong reading 4 - color image was printed onto this ink receptor sheet as described in example 1 and basically the same results were obtained as described in Example 1.

The same transfer element as in Example 1 was laminated to the imaged ink receptor sheet with an EasySprint® Desktop laminator at 115 °C roller temperature. After cooling to room temperature and a 1 min hold time, an attempt was made to peel off the temporary support of the transfer element. However, because of the insufficient adhesion of the imaged ink receiving layer to the temporary support, the imaged ink receiving layer was transferred to the transfer element. Because of this adhesion failure the printed image could not be transferred to a permanent substrate.

### Comparative Example 2

The solution for the ink receiving layer of Example 1 was directly coated onto a 100 µm thick corona treated polyester base which formed the temporary support of the ink receptor sheet as described in Example 1. The coating weight was 80 mg/dm².

A wrong reading 4 - color image was printed onto this ink receptor sheet as described in Example 1 and basically the same results were obtained as in Example 1.

The transfer element was laminated to the imaged ink receptor sheet with an EasySprint® Desktop laminator at 115 °C roller temperature. After cooling to room temperature and a 1 min. hold time, the temporary support of the transfer element was peeled off without any residues. The adhesive layer of the transfer element was completely transferred to the imaged ink receptor sheet without any adhesion failure or edge lifting at the ink receiving layer/temporary support interface.

The ink receptor sheet plus the adhesive layer of the transfer element were laminated to a 120 g/m2 Ikonorex® paper with an EasySprint® Desktop laminator at 115 °C roller temperature. After cooling to room temperature and a 1min. hold time, the temporary support of the ink receptor sheet could barely be peeled off. The surface of the ink receiving layer was damaged and some areas of the printed image were pulled off with the temporary support. The final proof was unusable.

## Claims

1. An ink receptor sheet comprising, in order:
(a) a first temporary support, and
(b) an ink receiving layer,
(c) **characterized in that** it further comprises a photopolymerizable layer between the first temporary support and the ink receiving layer, the photopolymerizable layer comprising at least one polymeric binder, at least one photopolymerizable, ethylenically unsaturated monomer, and at least one photoinitiator or photoinitiator system.

2. The ink receptor sheet according to Claim 1, **characterized in that** the adhesion between the photopolymerizable layer and the first temporary support decreases upon photopolymerization so that the first temporary support can be removed.

3. The ink receptor sheet according to Claims 1-2, **characterized in that** the photopolymerizable layer comprises at least one polymeric binder selected from the group consisting of polyvinylformal, polyvinyl butyral, polyvinyl alcohol, polyvinyl acetate, polyurethane esters, polyacrylates containing carboxylic groups, polymethacrylates, and copolymers of (meth)acrylic acid with (meth)acrylic esters, (meth)acrylic amides, vinyl compounds, styrene, and butadiene.

4. The ink receptor sheet according to Claims 1-3, **characterized in that** the photopolymerizable layer comprises at least one monomer selected from the group consisting of trimethylol propane trimethacrylate, bisacrylates or methacrylates of bisphenol A or its alkoxylated derivatives, and pentaerythritol tetraacrylate or methacrylate.

5. The ink receptor sheet according to Claims 1- 4, **characterized in that** the ink receiving layer comprises at least one hydrophilic polymer.

6. The ink receptor sheet according to Claims 1-5, **characterized in that** the ink receiving layer comprises at least one polymer selected from the group consisting of homo- and copolymers of vinly alcohol and/or pyrrolidone; homo- and copolymers of acrylic acid, methacrylic acid, and/or maleic acid and/or maleic acid anhydride, and/or their metal salts and/or their amine salts; gelatine, and starch.

7. An ink jet printing system comprising in combination:
(I) an ink receptor sheet according to claims 1-6 and
(II) a transfer element comprising:
(1) a second temporary support, and
(2) an adhesive layer.

8. The inkjet printing system according to Claim 7, **characterized in that** the adhesive layer of the transfer element comprises at least one thermoplastic polymer.

9. The ink jet printing system according to Claims 7-8, **characterized in that** the adhesive layer of the transfer element comprises at least one polymer selected from the group consisting of acrylate and methacrylate copolymers, vinyl acetate copolymers, and polyamides.

10. The ink jet printing system according to Claims 7-9, **characterized in that** the adhesive layer of the transfer element comprises at least one crystalline polymer.

11. The ink jet printing system according to Claims 7-10, **characterized in that** the adhesive layer of the transfer element comprises at least one polycaprolactone.

12. A process for preparing an image on a permanent substrate comprising the steps of:
(a) imagewise applying at least one ink image on an ink receptor sheet according to Claims 1-6, whereby the ink image is adjacent the ink receiving layer of the ink receptor,
(b) contacting the imaged ink receptor sheet with a transfer element according to Claims 7-11, whereby the ink image is adjacent the adhesive layer of the transfer element,
(c) removing the second temporary support to reveal the adhesive layer on top of the imaged ink receptor sheet,
(d) contacting the imaged ink receptor sheet with a permanent substrate, whereby the adhesive layer is adjacent the permanent substrate,
(e) overall exposing with actinic radiation the permanent substrate and imaged ink receptor sheet sandwich through the first temporary support, and
(f) removing the first temporary support to reveal the final image on the permanent substrate, wherein the image is encased between the ink receiving layer and the adhesive layer.

13. The process according to Claim 12, **characterized in that** contacting comprises laminating.

14. The process according to Claims 12-13, **characterized in that** the overall exposure of step (e) is carried out before instead of after step (d).

15. The process according to Claim 12-14, **characterized in that** it further comprises the following additional process steps, in order, between steps (a) and (b):
(g) laminating a photosensitive layer to the imaged ink receiving layer of the ink receptor sheet,
(h) imagewise exposing the photosensitive layer with actinic radiation to produce tacky and non-tacky areas, and
(i) applying a toner to the tacky areas.

16. The process according to Claim 15, **characterized in that** steps (g) to (i) are repeated at least once between steps (a) and (b), before carrying out steps (b) -(f).

17. The process according to Claims 15-16, **characterized in that** the photosensitive layer has a strippable base.

18. The process according to Claims 15-17, **characterized in that** the strippable base is removed before or after step (h).

19. The process according to Claims 15-18, **characterized in that** the photosensitive layer is a tacky, photopolymerizable layer.

20. The process according to Claims 15-19, **characterized in that** toner is selected from the group consisting of a pigmented toner powder and a pigmented foil in step (i).

21. A process for preparing an image on a permanent substrate comprising the steps of:
(a') imagewise applying at least one ink image onto an ink receiving layer of an ink receptor sheet according to Claims 1-6,
(b') contacting the imaged ink receptor sheet with a element comprising:
(I) a permanent support, and
(II) an adhesive layer, whereby the ink image is adjacent the adhesive layer
(c') overall exposing the imaged ink receptor sheet through the first temporary support with actinic radiation, and
(d') removing the first temporary support to reveal the final image on the permanent substrate.

22. The process according to Claim 21, **characterized in that** it further comprises the process, in order, between steps (a') and (b'):
(g') laminating a photosensitive layer to the imaged ink receiving layer of the ink receptor sheet,
(h') imagewise exposing the photosensitive layer with actinic radiation to produce tacky and non-tacky areas, and
(i') applying a toner to the tacky areas.

23. The process according to Claim 22, **characterized in that** steps (g') to (i') are repeated at least once between steps (a') and (b') before carrying out steps (b') -(d').

24. An imaged article comprising, in order:
(1) a permanent substrate,
(2) an adhesive layer,
(3) an ink image,
(4) an ink receiving layer, and
(5) a photopolymerized layer made from a photopolymerizable layer comprising at least one polymeric binder, at least one photopolymerizable, ethylenically unsaturated monomer, and at least one photoinitiator or photoinitiator system.

25. The imaged article according to Claim 24, **characterized in that** the ink image is formed by application of an ink jet ink.

26. The imaged article according to Claims 24-25, **characterized in that** it comprises at least one toned layer prepared according to Claims 15-20.

## Patentansprüche

1. Tintenempfangsblatt, das in der nachfolgenden Reihenfolge enthält:
(a) einen ersten vorübergehenden Träger, und
(b) eine die Tinte aufnehmende Lage,
(c) **dadurch gekennzeichnet, dass** dasselbe weiterhin eine photopolymerisierbare Lage zwischen dem ersten vorübergehenden Träger und der die Tinte aufnehmende Lage enthält, wobei die photopolymerisierbare Lage mindestens ein polymeres Bindemittel, mindestens ein photopolymerisierbares, ethylenisch ungesättigtes Monomer und mindestens einen Photoinitiator oder ein Photoinitiatorsystem umfasst.

2. Tintenempfangsblatt gemäß Anspruch 1, **dadurch gekennzeichnet, dass** die Haftung zwischen der photopolymerisierbaren Lage und dem ersten vorübergehenden Träger bei der Photopolymerisation derart abnimmt, dass der erste vorübergehende Träger entfernt werden kann.

3. Tintenempfangsblatt gemäß den Ansprüchen 1-2, **dadurch gekennzeichnet, dass** die photopolymerisierbare Lage mindestens ein polymeres Bindemittel aufweist, welches ausgewählt ist aus der Gruppe bestehend aus Polyvinylformal, Polyvinylbutyral, Polyvinylalkohol, Polyvinylacetat, Polyurethanester, aus Carboxylgruppen enthaltenden Polyacrylaten, Polymethacrylaten und aus Copolymeren von (Meth)acrylsäure mit (Meth)acrylestern, (Meth)acrylamiden, Vinylverbindungen, Styrol und Butadien.

4. Tintenempfangsblatt gemäß den Ansprüchen 1-3, **dadurch gekennzeichnet, dass** die photopolymerisierbare Lage mindestens ein Monomer umfasst, welches ausgewählt ist aus der Gruppe bestehend aus Trimethylolpropantrimethacrylat, aus Bisacrylaten oder Methacrylaten von Bisphenol A oder aus deren alkoxylierten Derivaten und aus Pentaerythritoltetraacrylat oder -methacrylat.

5. Tintenempfangsblatt gemäß den Ansprüchen 1-4, **dadurch gekennzeichnet, dass** die die Tinte aufnehmende Lage mindestens ein hydrophiles Polymer umfasst.

6. Tintenempfangsblatt gemäß den Ansprüchen 1-5, **dadurch gekennzeichnet, dass** die die Tinte aufnehmende Lage mindestens ein Polymer umfasst, welches ausgewählt ist aus der Gruppe bestehend aus Homo- und Copolymeren von Vinylalkohol und/oder Pyrrolidon; aus Homo- und Copolymeren von Acrylsäure, Methacrylsäure und/oder Maleinsäure und/oder Maleinsäureanhydrid, und/oder aus deren Metallsalzen und/oder deren Aminsalzen; aus Gelatine und Stärke.

7. System für ein Tintenstrahl-Druckverfahren, welches in Kombination enthält:
(I) ein Tintenempfangsblatt gemäß den Ansprüchen 1-6, und
(II) ein Übertragungselement, welches enthält:
(1) einen zweiten vorübergehenden Träger, und
(2) eine Haftlage.

8. System für ein Tintenstrahl-Druckverfahren gemäß Anspruch 7, **dadurch gekennzeichnet, dass** die Haftlage des Übertragungselementes mindestens ein thermoplastisches Polymer enthält.

9. System für ein Tintenstrahl-Druckverfahren gemäß den Ansprüchen 7-8, **dadurch gekennzeichnet, dass** die Haftlage des Übertragungselementes mindestens ein Polymer enthält, welches ausgewählt ist aus der Gruppe bestehend aus Acrylat- und Methacrylatcopolymeren, Vinylacetatcopolymeren und Polyamiden.

10. System für ein Tintenstrahl-Druckverfahren gemäß den Ansprüchen 7-9, **dadurch gekennzeichnet, dass** die Haftlage des Übertragungselementes mindestens ein kristallines Polymer enthält.

11. System für ein Tintenstrahl-Druckverfahren gemäß den Ansprüchen 7-10, **dadurch gekennzeichnet, dass** die Haftlage des Übertragungselementes mindestens ein Polycaprolacton enthält.

12. Verfahren zum Herstellen eines Bildes auf einem dauerhaften Substrat, welches die nachfolgenden Schritte aufweist:
(a) ein bildmäßiges Auftragen von mindestens einem Tintenbild auf ein Tintenempfangsblatt gemäß den Ansprüchen 1-6, wobei sich das Tintenbild in der Nachbarschaft der die Tinte aufnehmenden Lage des Tintenempfängers befindet,
(b) das mit einem Bild versehene Tintenempfangsblatt mit einem Übertragungselement gemäß den Ansprüchen 7-11 in Kontakt bringen, wobei sich das Tintenbild in der Nachbarschaft der Haftlage des Übertragungselements befindet,
(c) ein Entfernen des zweiten vorübergehenden Trägers, um die Haftlage oben auf dem mit dem Bild versehenen Tintenempfangsblatt frei zu legen,
(d) das mit dem Bild versehene Tintenempfangsblatt mit einem dauerhaften Substrat in Kontakt bringen, wobei sich die Haftlage in der Nachbarschaft des dauerhaften Substratträgers befindet,
(e) das dauerhafte Substrat und das mit dem Bild versehene Tintenempfangsblatt in ihrem Sandwichaufbau durch den ersten vorübergehenden Träger hindurch insgesamt einer aktinischen Strahlung aussetzen, und
(f) ein Entfernen des ersten vorübergehenden Trägers, um das endgültige Bild auf dem dauerhaften Substratträger frei zu legen, wobei das Bild zwischen der die Tinte aufnehmenden Lage und der Haftlage eingeschlossen wird.

13. Verfahren gemäß Anspruch 12, **dadurch gekennzeichnet, dass** die Herstellung eines Kontaktes in einer Laminierung besteht.

14. Verfahren gemäß den Ansprüchen 12-14, **dadurch gekennzeichnet, dass** die gesamte Aussetzung gemäß dem Schritt (e) vor dem Schritt (d) ausgeführt wird, anstatt dass dies nach diesem Schritt erfolgt.

15. Verfahren gemäß den Ansprüchen 12-14, **dadurch gekennzeichnet, dass** dasselbe weiterhin die nachfolgenden zusätzlichen Verfahrensschritte in der angegebenen Reihenfolge zwischen den Schritten (a) und (b) aufweist:
(g) ein Laminieren einer photoempfindlichen Lage auf die mit dem Bild versehene Tintenempfangslage des Tintenempfangsblattes,
(h) ein bildweises Aussetzen der photoempfindlichen Lage gegenüber einer aktinischen Strahlung, um klebrige und nicht klebrige Bereiche zu erzeugen, und
(i) ein Auftragen eines Toners auf die klebrigen Bereiche.

16. Verfahren gemäß Anspruch 15, **dadurch gekennzeichnet, dass** die Schritte (g) bis (i) mindestens einmal zwischen den Schritten (a) und (b) wiederholt werden, bevor die Schritte (b) - (f) ausgeführt werden.

17. Verfahren gemäß den Ansprüchen 15-16, **dadurch gekennzeichnet, dass** die photoempfindliche Lage eine Trennschicht als Grundschicht aufweist.

18. Verfahren gemäß den Ansprüchen 15-17, **dadurch gekennzeichnet, dass** die als Grundschicht dienende Trennschicht vor dem Schritt (h) entfernt wird oder anschließend an denselben.

19. Verfahren gemäß den Ansprüchen 15-18, **dadurch gekennzeichnet, dass** die photoempfindliche Lage aus einer klebrigen, photopolymerisierbaren Lage besteht.

20. Verfahren gemäß den Ansprüchen 15-19, **dadurch gekennzeichnet, dass** der Toner ausgewählt ist aus der Gruppe bestehend aus einem pigmentierten Tonerpulver und einer pigmentierten Folie in Schritt (i).

21. Verfahren zum Herstellen eines Bildes auf einem dauerhaften Substrat, welches die nachfolgenden Schritte aufweist:
(a') ein bildmäßiges Auftragen von mindestens einem Tintenbild auf eine die Tinte aufnehmende Lage eines Tintenempfangsblattes gemäß den Ansprüchen 1-6,
(b') das mit dem Bild versehene Tintenempfangsblatt mit einem Element in Kontakt bringen, welches enthält:
(I) einen dauerhaften Träger, und
(II) eine Haftlage, wobei sich das Tintenbild in der Nachbarschaft der Haftlage befindet,
(c') das mit dem Bild versehene Tintenempfangsblatt durch den ersten vorübergehenden Träger hindurch insgesamt einer aktinischen Strahlung auszusetzen, und
(d') ein Entfernen des ersten vorübergehenden Trägers, um das endgültige Bild auf dem dauerhaften Substratträger frei zu legen.

22. Verfahren gemäß Anspruch 21, **dadurch gekennzeichnet, dass** es weiterhin, zwischen den Schritten (a') und (b'), das Verfahren mit den nachfolgenden Schritten, in der angegebenen Reihenfolge, enthält:
(g') ein Laminieren einer photoempfindlichen Lage auf die mit dem Bild versehene Tintenempfangslage des Tintenempfangsblattes,
(h') ein bildweises Aussetzen der photoempfindlichen Lage gegenüber einer aktinischen Strahlung, um klebrige und nicht klebrige Bereiche zu erzeugen, und
(i') ein Auftragen eines Toners auf die klebrigen Bereiche.

23. Verfahren gemäß Anspruch 22, **dadurch gekennzeichnet, dass** die Schritte (g') bis (i') mindestens einmal zwischen den Schritten (a') und (b') wiederholt werden, bevor die Schritte (b') - (d') ausgeführt werden.

24. Mit einem Bild versehener Artikel, welcher in der angegebenen Reihenfolge enthält:
(1) einen dauerhaften Träger,
(2) eine Haftlage,
(3) ein Tintenbild,
(4) eine die Tinte aufnehmenden Lage, und
(5) eine photopolymerisierbare Lage, die aus einer photopolymerisierbaren Lage hergestellt ist, welche mindestens ein polymeres Bindemittel, mindestens ein photopolymerisierbares, ethylenisch ungesättigtes Monomer und mindestens einen Photoinitiator oder ein Photoinitiatorsystem umfasst.

25. Mit einem Bild versehener Artikel gemäß Anspruch 24, **dadurch gekennzeichnet, dass** das Tintenbild erzeugt wird durch ein Auftragen von Tinte eines Tintenstrahls.

26. Mit einem Bild versehener Artikel gemäß den Ansprüchen 24-25, **dadurch gekennzeichnet, dass** derselbe mindestens eine Tonerlage enthält, welche gemäß den Ansprüchen 15-20 erzeugt worden ist.

## Revendications

1. Feuille réceptrice d'encre comprenant, dans l'ordre:
(a) un premier support temporaire, et
(b) une couche réceptrice d'encre,
(c) **caractérisée en ce qu'**elle comprend en outre une couche photopolymérisable entre le premier support temporaire et la couche réceptrice d'encre, la couche photopolymérisable comprenant au moins un liant polymère, au moins un monomère photopolymérisable, éthyléniquement insaturé et au moins un photoinitiateur ou un système de photoinitiateur.

2. Feuille réceptrice d'encre suivant la revendication 1, **caractérisée en ce que** l'adhérence entre la couche photopolymérisable et le premier support temporaire diminue à la suite d'une photopolymérisation de sorte que le premier support temporaire peut être retiré.

3. Feuille réceptrice d'encre suivant les revendications 1-2, **caractérisée en ce que** la couche photopolymérisable comprend au moins un liant polymère choisi dans le groupe constitué de polyvinylformal, de polyvinylbutyral, de polyvinylalcool, de polyvinylacétate, d'esters de polyuréthane, de polyacrylates contenant des groupes carboxyliques, de polyméthacrylates et de copolymères d'acide (méth)acrylique avec des esters (méth)acryliques, des amides (méth)acryliques, des composés de vinyle, le styrène et le butadiène.

4. Feuille réceptrice d'encre suivant les revendications 1-3, **caractérisée en ce que** la couche photopolymérisable comprend au moins un monomère choisi dans le groupe constitué de triméthacrylate de triméthylolpropane, de bisacrylates ou de méthacrylates de bisphénol A ou ses dérivés alkoxylés et de tétraacrylate ou de méthacrylate de pentaérythritol.

5. Feuille réceptrice d'encre suivant les revendications 1-4, **caractérisée en ce que** la couche réceptrice d'encre comprend au moins un polymère hydrophile.

6. Feuille réceptrice d'encre suivant les revendications 1-5, **caractérisée en ce que** la couche réceptrice d'encre comprend au moins un polymère choisi dans le groupe constitué d'homo- et de copolymères de vinylalcool et/ou de pyrrolidone; d'homo- et de copolymères d'acide acrylique, d'acide méthacrylique et/ou d'acide maléique et/ou d'anhydride d'acide maléique et/ou leurs sels métalliques et/ou leurs sels d'amine; de gélatine et d'amidon.

7. Système d'impression par jet d'encre comprenant en combinaison:
(I) une feuille réceptrice d'encre suivant les revendications 1-6, et
(II) un élément de transfert comprenant:
(1) un deuxième support temporaire, et
(2) une couche adhésive.

8. Système d'impression par jet d'encre suivant la revendication 7, **caractérisé en ce que** la couche adhésive de l'élément de transfert comprend au moins un polymère thermoplastique.

9. Système d'impression par jet d'encre suivant les revendications 7-8, **caractérisé en ce que** la couche adhésive de l'élément de transfert comprend au moins un polymère choisi dans le groupe constitué de copolymères d'acrylate et de méthacrylate, de copolymères de vinylacétate et de polyamides.

10. Système d'impression par jet d'encre suivant les revendications 7-9, **caractérisé en ce que** la couche adhésive de l'élément de transfert comprend au moins un polymère cristallin.

11. Système d'impression par jet d'encre suivant les revendications 7-10, **caractérisé en ce que** la couche adhésive de l'élément de transfert comprend au moins une polycaprolactone.

12. Procédé pour la préparation d'une image sur un substrat permanent, comprenant les étapes:
(a) d'application par image d'au moins une image d'encre sur une feuille réceptrice d'encre suivant les revendications 1-6, en conséquence de quoi l'image d'encre est adjacente à la couche réceptrice d'encre du récepteur d'encre,
(b) de mise en contact de la feuille réceptrice d'encre imagée avec un élément de transfert suivant les revendications 7-11, en conséquence de quoi l'image d'encre est adjacente à la couche adhésive de l'élément de transfert,
(c) de retrait du deuxième support temporaire pour révéler la couche adhésive sur le dessus de la feuille réceptrice d'encre imagée,
(d) de mise en contact de la feuille réceptrice d'encre imagée avec un substrat permanent, en conséquence de quoi la couche adhésive est adjacente au substrat permanent,
(e) d'exposition d'ensemble avec un rayonnement actinique du substrat permanent et de la feuille réceptrice d'encre imagée en sandwich à travers le premier support temporaire, et
(f) de retrait du premier support temporaire pour révéler l'image finale sur le substrat permanent, où l'image est encastrée entre la couche réceptrice d'encre et la couche adhésive.

13. Procédé suivant la revendication 12, **caractérisé en ce que** la mise en contact comprend un laminage.

14. Procédé suivant les revendications 12-13, **caractérisé en ce que** l'exposition d'ensemble de l'étape (e) est réalisée avant au lieu d'après l'étape (d).

15. Procédé suivant les revendications 12-14, **caractérisé en ce qu'**il comprend en outre les étapes de procédé supplémentaires suivantes, dans l'ordre, entre les étapes (a) et (b):
(g) laminage d'une couche photosensible sur la couche réceptrice d'encre imagée de la feuille réceptrice d'encre,
(h) exposition par image de la couche photosensible avec un rayonnement actinique pour produire des zones poisseuses et non poisseuses, et
(i) application d'un toner sur les zones poisseuses.

16. Procédé suivant la revendication 15, **caractérisé en ce que** les étapes (g) à (i) sont répétées au moins une fois entre les étapes (a) et (b), avant de réaliser les étapes (b)-(f).

17. Procédé suivant les revendications 15-16, **caractérisé en ce que** la couche photosensible possède une base détachable.

18. Procédé suivant les revendications 15-17, **caractérisé en ce que** la base détachable est retirée avant ou après l'étape (h).

19. Procédé suivant les revendications 15-18, **caractérisé en ce que** la couche photosensible est une couche poisseuse, photopolymérisable.

20. Procédé suivant les revendications 15-19, **caractérisé en ce que** le toner est choisi dans le groupe constitué d'une poudre de toner pigmentée et d'une feuille pigmentée dans l'étape (i).

21. Procédé pour la préparation d'une image sur un substrat permanent comprenant les étapes:
(a') d'application par image d'au moins une image d'encre sur une couche réceptrice d'encre d'une feuille réceptrice d'encre suivant les revendications 1-6,
(b') de mise en contact de la feuille réceptrice d'encre imagée avec un élément comprenant:
(I) un support permanent, et
(II) une couche adhésive, en conséquence de quoi l'image d'encre est adjacente à la couche adhésive,
(c') d'exposition d'ensemble de la feuille réceptrice d'encre imagée à travers le premier support temporaire avec un rayonnement actinique, et
(d') de retrait du premier support temporaire pour révéler l'image finale sur le substrat permanent.

22. Procédé suivant la revendication 21, **caractérisé en ce qu'**il comprend en outre le procédé, dans l'ordre, entre les étapes (a') et (b'):
(g') laminage d'une couche photosensible sur la couche réceptrice d'encre imagée de la feuille réceptrice d'encre,
(h') exposition par image de la couche photosensible avec un rayonnement actinique pour produire des zones poisseuses et non poisseuses, et
(i') application d'un toner sur les zones poisseuses.

23. Procédé suivant la revendication 22, **caractérisé en ce que** les étapes (g') à (i') sont répétées au moins une fois entre les étapes (a') et (b') avant la réalisation des étapes (b')-(d').

24. Article imagé comprenant, dans l'ordre:
(1) un substrat permanent,
(2) une couche adhésive,
(3) une image d'encre,
(4) une couche réceptrice d'encre, et
(5) une couche photopolymérisée fabriquée à partir d'une couche photopolymérisable comprenant au moins un liant polymère, au moins un monomère photopolymérisable, éthyléniquement insaturé et au moins un photoinitiateur ou un système de photoinitiateur.

25. Article imagé suivant la revendication 24, **caractérisé en ce que** l'image d'encre est formée par l'application d'une encre de jet d'encre.

26. Article imagé suivant les revendications 24-25, **caractérisé en ce qu'**il comprend au moins une couche avec un toner préparée suivant les revendications 15-20.
